# EUROPEAN PATENT APPLICATION

(11) **EP 4 531 527 A1**
(43) Date of publication of application: **02.04.2025**
(21) Application number: 24203036.9
(22) Date of filing: 26.09.2024
(51) Int. Cl.: H10K 59/38

(54) **DISPLAY DEVICE**

(30) Priority: 27.09.2023 KR 20230130126
(71) Applicant: Samsung Display Co., Ltd., Gyeonggi-do 17113 (KR)
(72) Inventor: HONG, Sang Min, 17113 Yongin-si (KR); KIM, Hyomin, 17113 Yongin-si (KR); SUNG, Sijin, 17113 Yongin-si (KR)
(74) Representative: Taor, Simon Edward William

(57) **Abstract**

A display device includes a base layer including a light-emitting region and a non-light-emitting region adjacent to the light-emitting region, a display element layer disposed on the base layer and including a light-emitting element corresponding to the light-emitting region, and a color filter disposed on the display element layer and including a colorant. The color filter includes a first portion overlapping the light-emitting region, and a second portion surrounding the first portion, and a first weight percent of the colorant with respect to a total weight of the first portion is smaller than a second weight percent of the colorant with respect to a total weight of the second portion.

## Description

This application claims priority to Korean Patent Application No. 10-2023-0130126, filed on September 27, 2023.

### BACKGROUND

### 1. Field

The disclosure herein relates to a display device, and more particularly, to a display device having improved display efficiency.

### 2. Description of the Related Art

Various display devices used in multimedia apparatuses such as televisions, mobile phones, tablet computers, and game consoles are being developed. A display device may include various optical functional layers so as to provide a color image of excellent quality to a user.

Research on thin display devices is being conducted to achieve display devices in various forms such as a display device having a curved surface, a rollable display device, or a foldable display device. A thin display device may be achieved by reducing the number of optical functional layers and including an optical functional layer having various functions.

### SUMMARY

The disclosure provides a display device having improved display quality due to reduced external light reflection and reduced color deviation according to a viewing angle.

An embodiment of the inventive concept provides a display device including a base layer including a light-emitting region and a non-light-emitting region adjacent to the light-emitting region, a display element layer disposed on the base layer and including a light-emitting element corresponding to the light-emitting region, and a color filter disposed on the display element layer and including a colorant. The color filter includes a first portion overlapping the light-emitting region, and a second portion surrounding the first portion, and a first weight percent of the colorant with respect to a total weight of the first portion is smaller than a second weight percent of the colorant with respect to a total weight of the second portion.

In an embodiment, the colorant may include a dye or a pigment.

In an embodiment, the second portion may overlap the light-emitting region and the non-light-emitting region.

In an embodiment, the light-emitting element may emit source light, and the color filter may absorb at least portion of the source light.

In an embodiment, with respect to the source light, a first light transmittance of the first portion may be higher than a second light transmittance of the second portion.

In an embodiment, the second light transmittance may be about 82 percent (%) to about 90% of the first light transmittance.

In an embodiment, the display device may further include a division pattern apposed to the color filter on the display element layer and overlapping the non-light-emitting region, and with respect to the source light, a light transmittance of the division pattern may be lower than the second light transmittance.

In an embodiment, an absorbance of the first portion with respect to the source light may be lower than an absorbance of the second portion with respect to the source light.

In an embodiment, a centerline which is virtual may be defined in the light-emitting region in a plan view, and the first portion may be defined as a portion adjacent to the centerline.

In an embodiment, the light-emitting element may emit source light, and a light transmittance of the color filter with respect to the source light may become lower in a direction of getting farther away from the centerline in the plan view.

In an embodiment, the light-emitting region may have a first width with respect to a first direction from the centerline, the first portion may have a second width with respect to the first direction from the centerline to correspond to the light-emitting region, and a ratio of the second width to the first width may be about 0.4 to about 0.6.

In an embodiment, the first width may be about 6 micrometers (µm) to about 20 µm, and the second width may be about 3 µm to about 10 µm.

In an embodiment, the display device may further include an overcoat layer which covers the color filter and overlapping an entirety of the light-emitting region and the non-light-emitting region.

In an embodiment of the inventive concept, a display device includes a base layer including a first light-emitting region, a second light-emitting region, a third light-emitting region, which are spaced apart from each other in a plan view, and a non-light-emitting region defined between the first to third light-emitting regions, a display element layer disposed on the base layer and including first to third light-emitting elements corresponding to the first to third light-emitting regions, and a color filter layer disposed on the display element layer. The color filter layer includes a first filter part overlapping the first light-emitting region and including a first colorant, a second filter part overlapping the second light-emitting region and including a second colorant, and a third filter part overlapping the third light-emitting region. The first filter part includes a first portion having a first concentration of the first colorant, and a second portion having a second concentration of the first colorant, and the first concentration is lower than the second concentration.

In an embodiment, a concentration of the second colorant in the second filter part may be substantially uniform in the second light-emitting region.

In an embodiment, the first to third light-emitting elements may respectively emit first to third light, and a light transmittance of the first portion with respect to the first light may be higher than a light transmittance of the second portion with respect to the first light.

In an embodiment, the first light may be red light, the second light may be green light, and the third light may be blue light.

In an embodiment, a light transmittance of the second filter part with respect to the second light may be substantially same in the second light-emitting region, and a light transmittance of the third filter part with respect to the third light may be substantially same in the third light-emitting region.

In an embodiment, the color filter layer may further include a division pattern overlapping the non-light-emitting region.

In an embodiment, each of the first to third filter parts may extend up to the non-light-emitting region, and the division pattern may have a structure in which at least a portion of the first to third filter parts is stacked.

According to an aspect, there is provided a display device as set out in claim 1. Additional features are set out in claims 2 to 15.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a perspective view of an embodiment of a display device according to the inventive concept;
FIG. 2 is a cross-sectional view of an embodiment of a display device according to the inventive concept;
FIG. 3 is an enlarged plan view of an embodiment of a portion of a display module according to the inventive concept;
FIG. 4A is a cross-sectional view of an embodiment of a display device according to the inventive concept;
FIG. 4B is a cross-sectional view of a display device according to the inventive concept;
FIG. 5 is an enlarged cross-sectional view of a portion of a display device according to the inventive concept;
FIG. 6 is a plan view illustrating some components of a display device according to the inventive concept;
FIG. 7A is a graph showing Embodiment of color coordinates versus viewing angles; and
FIG. 7B is a graph showing Comparative Example of color coordinates versus viewing angles.

### DETAILED DESCRIPTION

Hereinafter, embodiments of the inventive concept will be described with reference to the accompanying drawings.

In this specification, when an element (or a region, a layer, a portion, etc.) is referred to as being "on", "connected to" or "coupled to" another element, it may be directly on, connected or coupled to the other element, or intervening elements may be disposed therebetween.

Like numerals or symbols refer to like elements throughout. In addition, in the drawings, thicknesses, ratios, and dimensions of elements are exaggerated for effective description of the technical contents. The term "and/or" includes all of one or more combinations that the associated elements may define.

Although the terms first, second, etc. may be used to describe various elements, these elements should not be limited by these terms. These terms are only used to distinguish one element from another element. For example, a first element may be referred to as a second element, and similarly, a second element may also be referred to as a first element without departing from the scope of the inventive concept. The singular forms include the plural forms as well, unless the context clearly indicates otherwise.

In addition, terms such as "below", "lower", "above", "upper" are used to describe the relationships of the elements illustrated in the drawings. The terms are relative concepts and are described on the basis of the directions indicated in the drawings.

It will be understood that the terms such as "include" or "have", when used herein, are intended to specify the presence of stated features, integers, steps, operations, elements, components, or combinations thereof, but do not preclude the presence or addition of one or more other features, integers, steps, operations, elements, components, or combinations thereof.

As used herein, "directly disposed" may mean that there is no intervening layer, film, region, plate, etc., added between a portion of a layer, film, region, plate, etc. and another portion thereof. For example, "directly disposed" may mean that two layers or two members are disposed without using an additional member such as an adhesive member therebetween.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art. In addition, terms such as those defined in commonly used dictionaries should be interpreted as having a meaning that is consistent with their meaning in the context of the relevant art and will not be interpreted in an overly idealized or overly formal sense unless expressly so defined herein.

Hereinafter, a display device in an embodiment of the inventive concept will be described with reference to the accompanying drawings.

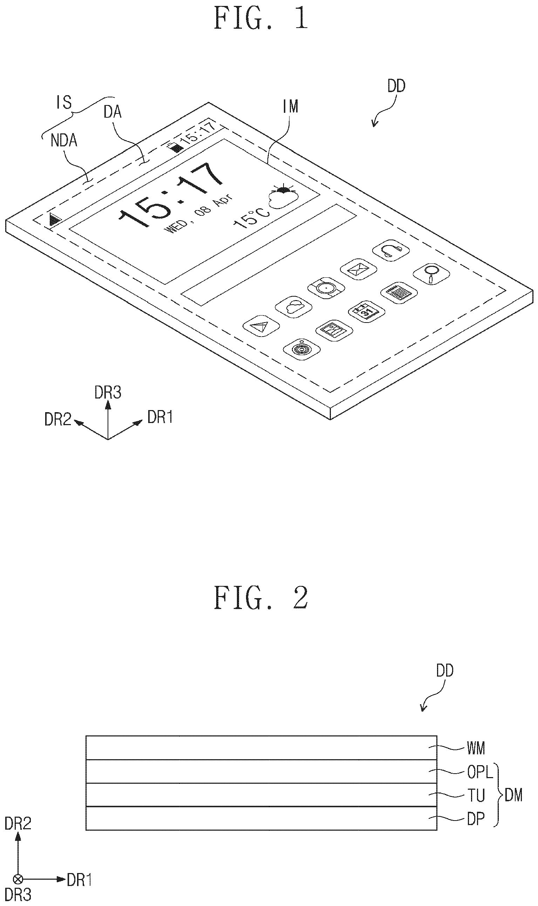

FIG. 1 is a perspective view of an embodiment of a display device according to the inventive concept. FIG. 1 illustrates a portable electronic apparatus in an embodiment of a display device DD. However, the display device DD may be used in a large-sized electronic apparatus such as a television, a monitor, or an outdoor billboard, as well as a small- or medium-sized electronic apparatus such as a personal computer, a laptop, a personal digital assistant, a car navigation unit, a game console, a smartphone, a tablet personal computer ("PC"), and a camera. In addition, these are simply presented as illustrative embodiments, and thus the display device DD may also be employed in other electronic apparatuses without departing from the scope of the inventive concept.

The display device DD may have a hexahedral form having a thickness in a third direction DR3 on a plane defined by a first direction DR1 and a second direction DR2 crossing each other. However, this is illustrated as one of embodiments, and the display device DD may have various forms, and the inventive concept is not limited thereto. As used herein, the wording "in a plan view" may be defined as being viewed in the third direction DR3. As used herein, the wording "in a cross-section" may be defined as being viewed in the first direction DR1 or the second direction DR2. Directions indicated by the first to third directions DR1, DR2, and DR3 may have relative concepts, and may thus be changed into other directions.

In an embodiment, an upper surface (or a front surface) and a lower surface (or a rear surface) of each member are defined on the basis of a direction in which an image IM is displayed. The upper surface and the lower surface may be opposed to each other in the third direction DR3, and a normal direction of each of the upper surface and the lower surface may be parallel to the third direction DR3.

The display device DD may display the image IM through a display surface IS. The display surface IS includes a display region DA where the image IM is displayed, and a non-display region NDA adjacent to the display region DA. The non-display region NDA is a region where the image is not displayed. The image IM may be a dynamic image or a still image. FIG. 1 illustrates a plurality of application icons, a clock, etc., as embodiments of the image IM.

The display region DA may have a quadrangular shape. The non-display region NDA may surround the display region DA. However, this is an illustrative embodiment, and the inventive concept is not limited thereto. Thus, a shape of the display region DA and a shape of the non-display region NDA may be relatively designed. In addition, the non-display region NDA may not be on a front surface of the display device DD.

The display device DD may be flexible. This may imply a bendable property, and the display device DD may be a device including any one from among a structure which is completely foldable to a structure which is bendable to a level of several nanometers. In an embodiment, the display device DD may be a curved display device or a foldable display device, for example. However, embodiments of the inventive concept are not limited thereto, and the display device DD may be rigid.

FIG. 2 is a cross-sectional view of an embodiment of a display device according to the inventive concept.

A display device DD may include a display module DM and a window WM. The display module DM may include a display panel DP, a sensor layer TU, and an optical layer OPL, which are sequentially stacked. However, a component of the display device DD is not limited thereto, and the display device DD may not include the optical layer OPL or the window WM in other embodiments.

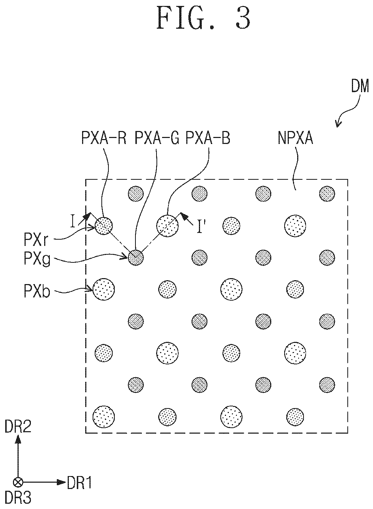

The display panel DP may include a plurality of pixels in a region corresponding to the display device DD. The plurality of pixels may correspond to a plurality of light-emitting regions PXA-R, PXA-G, and PXA-B (refer to FIG. 3). The plurality of pixels may display light in response to an electrical signal. The display panel DP may be a self-luminous display panel. In an embodiment, the display panel DP may be a micro-light-emitting diode ("micro-LED") display panel, a nano-LED display panel, an organic light-emitting display panel, or a quantum dot light-emitting display panel, for example. However, these are merely illustrative embodiments, and embodiments of the inventive concept are not limited thereto as long as the display panel DP is a self-luminous display panel.

A light-emitting layer of the organic light-emitting display panel may include an organic light-emitting material. A light-emitting layer of the quantum dot light-emitting display panel may include quantum dots and/or quantum rods, etc. The micro-LED display panel may include a micro-light-emitting diode element that is an ultrasmall light-emitting element, and the nano-LED display panel may include a nano-light-emitting diode element. Hereinafter, the display panel DP will be described as an organic light-emitting display panel.

The sensor layer TU may acquire, in response to an external input, information for generating an image on the display panel DP. The external input may be a user's input. The user's input may include external inputs in various forms such as a body part of a user, light, heat, a pen, or pressure. The sensor layer TU may be disposed on the display panel DP. The sensor layer TU may be formed on the display panel DP through a continuous process. In this case, it may be mentioned that the sensor layer TU is directly disposed on the display panel DP. Being directly disposed may mean that no intervening element is disposed between the sensor layer TU and the display panel DP. That is, no additional adhesive member may be disposed between the sensor layer TU and the display panel DP. In an alternative embodiment, the sensor layer TU may be bonded to the display panel DP through an adhesive member. The adhesive member may include typical adhesive agent or bonding agent.

The optical layer OPL may reduce a reflectance for external light incident from outside the display device DD. The optical layer OPL may be an anti-reflective layer which reduces a reflectance for external light incident from the outside. The optical layer OPL may be a layer which selectively transmits light emitted from the display panel DP. The optical layer OPL may not include a polarizing layer. Accordingly, light passing through the optical layer OPL and incident onto the display panel DP and the sensor layer TU may be unpolarized light. The optical layer OPL may be disposed on the sensor layer TU. The optical layer OPL may be directly disposed on the sensor layer TU. However, embodiments of the inventive concept are not limited thereto, and an adhesive member may be disposed between the optical layer OPL and the sensor layer TU.

The window WM may include an optically transparent insulating material. In an embodiment, the window WM may include glass or plastic, for example. The window WM may have a multi-layered structure or a single-layered structure. In an embodiment, the window WM may include a plurality of plastic films bonded with an adhesive agent, or a glass substrate and a plastic film bonded with an adhesive agent, for example. The window WM may be disposed on the optical layer OPL. An adhesive member may be disposed between the optical layer OPL and the window WM, but embodiments of the inventive concept are not limited thereto.

FIG. 3 is an enlarged plan view of an embodiment of a portion of a display module DM.

Referring to FIG. 3, the display module DM may include a plurality of pixels PXr, PXg, and PXb. The pixels PXr, PXg, and PXb may include a first pixel PXr, a second pixel PXg, and a third pixel PXb.

A first light-emitting region PXA-R may be defined in the first pixel PXr, and a second light-emitting region PXA-G may be defined in the second pixel PXg, and a third light-emitting region PXA-B may be defined in the third pixel PXb. Circular shapes illustrated in FIG. 3 may respectively correspond to shapes of the first to third light-emitting regions PXA-R, PXA-G, and PXA-B. However, the respective shapes of the first to third light-emitting regions PXA-R, PXA-G, and PXA-B are not limited thereto in embodiments. In an embodiment, the first to third light-emitting regions PXA-R, PXA-G, and PXA-B may have oval shapes in a plan view, for example. In an alternative embodiment, the first to third light-emitting regions PXA-R, PXA-G, and PXA-B may have various shapes in a plan view such as quadrangles, polygons, triangles, or arbitrary shapes.

In an embodiment of the inventive concept, the first pixel PXr and the third pixel PXb may be alternately and repeatedly disposed in each of a first direction DR1 and a second direction DR2. The second pixel PXg may be disposed in a space between two first pixels PXr adjacent to each other in a diagonal direction and two third pixels PXb adjacent to each other in a diagonal direction. However, an arrangement relationship of the first to third pixels PXr, PXg, and PXb illustrated in FIG. 3 is one of embodiments, and an arrangement relationship of the first to third pixels PXr, PXg, and PXb of embodiments is not particularly limited thereto. The diagonal direction may be a direction between the first direction DR1 and the second direction DR2, or a direction between a complete opposite direction of the first direction DR1 and the second direction DR2.

Any one of the first to third light-emitting regions PXA-R, PXA-G, and PXA-B may emit first light, and another may emit second light different from the first light, and the other may emit third light different from the first light and the second light. In an embodiment, the first light-emitting region PXA-R may emit red light, and the second light-emitting region PXA-G may emit green light, and the third light-emitting region PXA-B may emit blue light, for example.

In an embodiment of the inventive concept, the third light-emitting region PXA-B may have a largest area, and the second light-emitting region PXA-G may have a smallest area. However, embodiments of the inventive concept are not particularly limited thereto. Areas of the first to third light-emitting regions PXA-R, PXA-G, and PXA-B may be set according to color(s) of emitted light. In an embodiment, the areas of the first to third light-emitting regions PXA-R, PXA-G, and PXA-B may be the same, or may be different from an illustrated example, for example.

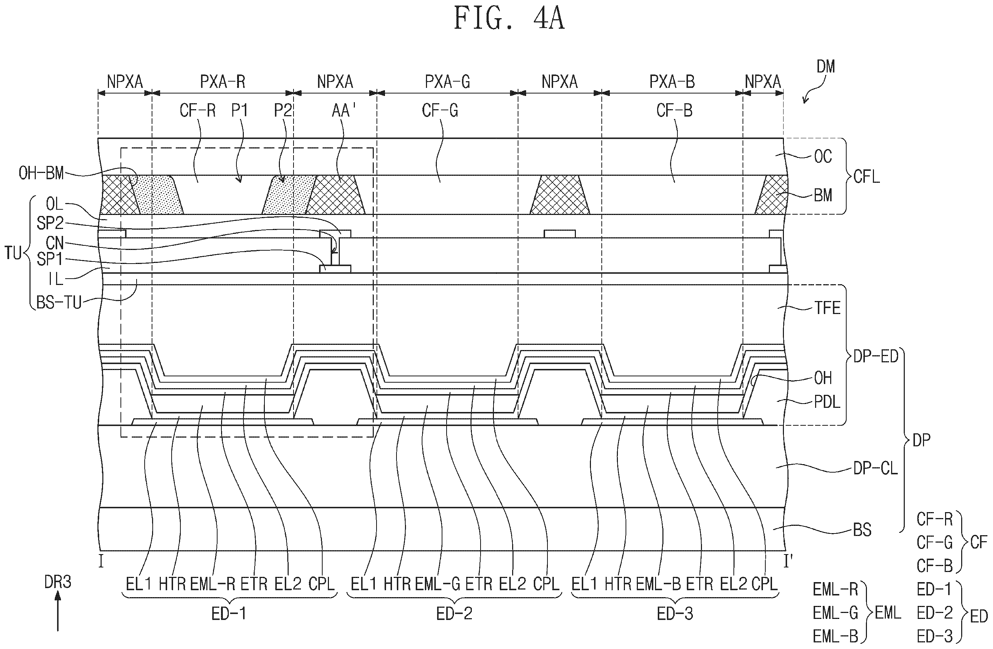

A non-light-emitting region NPXA may be disposed around the first to third light-emitting regions PXA-R, PXA-G, and PXA-B. The non-light-emitting region NPXA may set boundaries of the first to third light-emitting regions PXA-R, PXA-G, and PXA-B. The non-light-emitting region NPXA may surround the first to third light-emitting regions PXA-R, PXA-G, and PXA-B. In the non-light-emitting region NPXA, a structure, which prevents color mixing between the first to third light-emitting regions PXA-R, PXA-G, and PXA-B, e.g., a pixel-defining film PDL (refer to FIG. 4A), may be disposed.

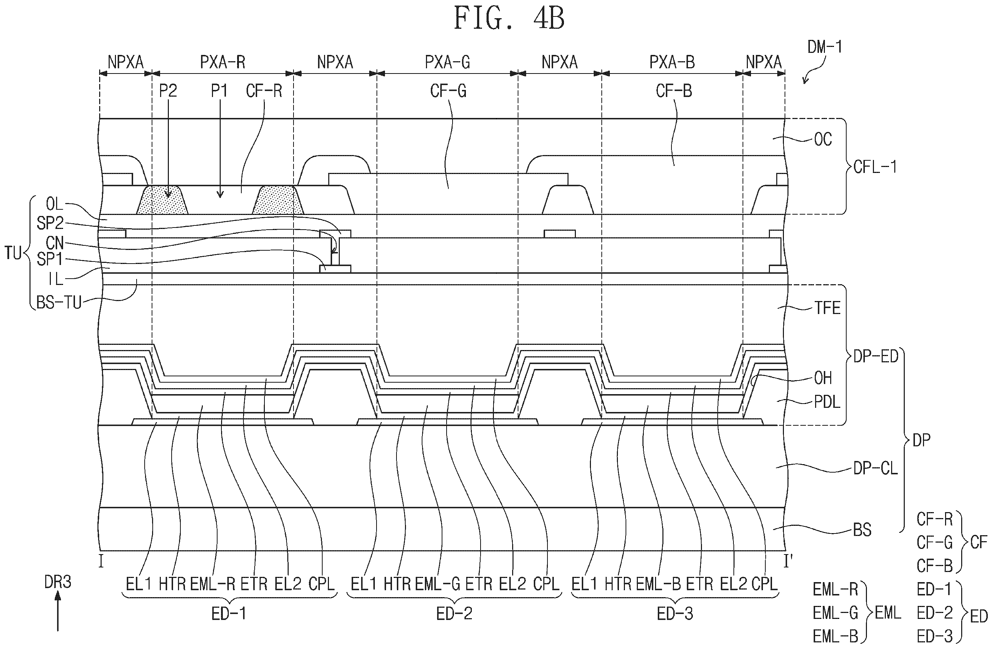

FIG. 4A is a cross-sectional view of an embodiment of a display device according to the inventive concept. FIG. 4B is a cross-sectional view of an embodiment of a display device according to the inventive concept. Each of FIG. 4A and FIG. 4B is a cross-sectional view taken along line I-I' in FIG. 3.

Referring to FIG. 4A, a display module DM in an embodiment may include a display panel DP, a sensor layer TU disposed on the display panel, and a color filter layer CFL disposed on the sensor layer TU.

The display panel DP may include a base layer BS, a circuit layer DP-CL, and a display element layer DP-ED, which are sequentially stacked. The display element layer DP-ED may include a pixel-defining film PDL, light-emitting elements ED having light-emitting layers EML disposed in a plurality of pixel openings OH defined in the pixel-defining film PDL, and an encapsulation layer TFE disposed on the light-emitting elements ED.

In the display panel DP, the base layer BS may be a member which provides a base surface on which the display element layer DP-ED is disposed. The base layer BS may be rigid or flexible. The base layer BS may be a glass substrate, a metal substrate, or a polymer substrate. However, embodiments of the inventive concept are not limited thereto, and the base layer BS may be an inorganic layer, an organic layer, or a composite material layer.

The base layer BS may have a multi-layered structure as well as a single-layered structure. In an embodiment, the base layer BS may have a three-layered structure of a polymer resin layer, an adhesive layer, and a polymer resin layer, for example. Specifically, the polymer resin layer may include a polyimide-based resin. In addition, the polymer resin layer may include at least one of an acrylate-based resin, a vinyl-based resin, an epoxy-based resin, a urethane-based resin, a cellulose-based resin, a siloxane-based resin, or a perylene-based resin. As used herein, a "component-based" resin means a resin including a functional group of the component.

The circuit layer DP-CL may be disposed on the base layer BS. The circuit layer DP-CL may include an insulating layer, a semiconductor pattern, a conductive pattern, a signal line, etc. The circuit layer DP-CL may include a plurality of transistors (not illustrated) including or consisting of a semiconductor pattern, a conductive pattern, a signal line, etc. Each of the transistors (not illustrated) may include a control electrode, an input electrode, and an output electrode. In an embodiment, the circuit layer DP-CL may include a driving transistor and a switching transistor for driving a light-emitting element ED, for example.

The display element layer DP-ED may be disposed on the circuit layer DP-CL. The display element layer DP-ED may include the pixel-defining film PDL, the light-emitting element ED, and the encapsulation layer TFE. In an embodiment, the display element layer DP-ED may include a plurality of light-emitting elements ED-1, ED-2, and ED-3.

Each of the light-emitting elements ED-1, ED-2, and ED-3 may include a first electrode EL1, a second electrode EL2 facing the first electrode EL1, and a light-emitting layer EML disposed between the first electrode EL1 and the second electrode EL2. In addition, each of the light-emitting elements ED-1, ED-2, and ED-3 may further include a hole transport region HTR and an electron transport region ETR. Each of the light-emitting elements ED-1, ED-2, and ED-3 may also further include a capping layer CPL disposed on the second electrode EL2.

In the display element layer DP-ED, a first light-emitting element ED-1 may include a first light-emitting layer EML-R overlapping a first light-emitting region PXA-R, and a second light-emitting element ED-2 may include a second light-emitting layer EML-G overlapping a second light-emitting region PXA-G. A third light-emitting element ED-3 may include a third light-emitting layer EML-B overlapping a third light-emitting region PXA-B.

As used herein, the wording "overlapping" of two components is not limited to a case in which the two components have the same area and the same shape in a plan view and includes a case in which the two components have different areas and/or different shapes. The plane refers to a plane perpendicular to a thickness direction.

The pixel-defining film PDL may be disposed on the circuit layer DP-CL. The plurality of pixel openings OH may be defined in the pixel-defining film PDL. At least a portion of the first electrode EL1 may be exposed in the pixel openings OH of the pixel-defining film PDL.

The pixel openings OH defined in the pixel-defining film PDL may respectively correspond to light-emitting regions PXA-R, PXA-G, and PXA-B. A non-light-emitting region NPXA may be a region between neighboring light-emitting regions PXA-R, PXA-G, and PXA-B and may be a region corresponding to the pixel-defining film PDL.

The pixel-defining film PDL may include an organic resin or an inorganic material. In an embodiment, the pixel-defining film PDL may be formed while including a polyacrylate-based resin, a polyimide-based resin, silicon nitride (SiNₓ), silicon oxide (SiOₓ), silicon oxynitride (SiOₓN_{y}), or the like, for example.

In addition, in an embodiment, the pixel-defining film PDL may have a light-absorbing property, and for example, may have a black color. The pixel-defining film PDL may include a black coloring agent. The black coloring agent may include a black dye or a black pigment. The pixel-defining film PDL may correspond to a light-shielding pattern having a light-shielding property.

FIG. 4A and FIG. 4B illustrate embodiments in which the respective light-emitting layers EML-R, EML-G, and EML-B of the light-emitting elements ED-1, ED-2, and ED-3 are disposed in the pixel openings OH defined in the pixel-defining film PDL, and the hole transport region HTR, the electron transport region ETR, the second electrode EL2, and the capping layer CPL are provided as common layers in all of the light-emitting elements ED-1, ED-2, and ED-3. However, embodiments of the inventive concept are not limited thereto, and in an embodiment, unlike what are illustrated in FIG. 4A and FIG. 4B, at least one among the hole transport region HTR, the electron transport region ETR, the second electrode EL2, and the capping layer CPL may be provided by being patterned in a pixel opening OH defined in the pixel-defining film PDL. In an embodiment, at least one among the hole transport region HTR, the electron transport region ETR, the second electrode EL2, the capping layer CPL, and the light-emitting layers EML-R, EML-G, or EML-B of the light-emitting elements ED-1, ED-2, or ED-3 may be provided by being patterned through an inkjet printing method.

In the display module DM in an embodiment, the plurality of light-emitting elements ED-1, ED-2, and ED-3 may emit light in different wavelength ranges. In an embodiment, in an embodiment, the display module DM may include the first light-emitting element ED-1 which emits red light, the second light-emitting element ED-2 which emits green light, and the third light-emitting element ED-3 which emits blue light, for example. That is, a red light-emitting region PXA-R, a green light-emitting region PXA-G, and a blue light-emitting region PXA-B in a display device in an embodiment may respectively correspond to the first light-emitting element ED-1, the second light-emitting element ED-2, and the third light-emitting element ED-3. However, embodiments of the inventive concept are not limited thereto, and the first to third light-emitting elements ED-1, ED-2, and ED-3 may emit light in the same wavelength range, or at least one thereof may emit light in a wavelength range different from the others. In an embodiment, all of the first to third light-emitting elements ED-1, ED-2, and ED-3 may emit blue light, for example.

In the light-emitting element ED, the first electrode EL1 may be disposed on the circuit layer DP-CL. The first electrode EL1 may be an anode or a cathode. In addition, the first electrode EL1 may be a pixel electrode. The first electrode EL1 may be a transmissive electrode, a transflective electrode, or a reflective electrode.

The hole transport region HTR may be disposed between the first electrode EL1 and the light-emitting layer EML. The hole transport region HTR may include at least one of a hole injection layer, a hole transport layer, or an electron blocking layer. The hole transport region HTR may be disposed as a common layer so as to overlap an entirety of the light-emitting regions PXA-R, PXA-G, and PXA-B and the pixel-defining film PDL separating the light-emitting regions PXA-R, PXA-G, and PXA-B. However, embodiments of the inventive concept are not limited thereto, and the hole transport region HTR may be provided through patterning so that patterned hole transport regions are separately disposed to respectively correspond to the light-emitting regions PXA-R, PXA-G, and PXA-B.

The light-emitting layer EML may be disposed on the first electrode EL1. The light-emitting layer EML may include a plurality of light-emitting layers EML-R, EML-G, and EML-B. The first light-emitting layer EML-R may overlap the first light-emitting region PXA-R and emit first light. The second light-emitting layer EML-G may overlap the second light-emitting region PXA-G and emit second light. The third light-emitting layer EML-B may overlap the third light-emitting region PXA-B and emit third light. In the light-emitting elements ED-1, ED-2, and ED-3 in an embodiment, the first to third light may have substantially different wavelength ranges. In an embodiment, the first light may be red light in a wavelength range of about 625 nanometers (nm) to about 675 nm, and the second light may be green light in a wavelength range of about 500 nm to about 570 nm, and the third light may be blue light in a wavelength range of about 410 nm to about 480 nm, for example.

The electron transport region ETR may be disposed between the light-emitting layer EML and the second electrode EL2. The electron transport region ETR may include at least one of an electron injection layer, an electron transport layer, or a hole blocking layer. The electron transport region ETR may be disposed as a common layer so as to overlap an entirety of the light-emitting regions PXA-R, PXA-G, and PXA-B and the pixel-defining film PDL separating the light-emitting regions PXA-R, PXA-G, and PXA-B. However, embodiments of the inventive concept are not limited thereto, and the electron transport region ETR may be provided through patterning so that patterned electron transport regions are separately disposed to respectively correspond to the light-emitting regions PXA-R, PXA-G, and PXA-B.

The second electrode EL2 is provided on the electron transport region ETR. The second electrode EL2 may be a common electrode. The second electrode EL2 may be a cathode or an anode, but embodiments of the inventive concept are not limited thereto. In an embodiment, when the first electrode EL1 is an anode, the second electrode EL2 may be a cathode, and when the first electrode EL1 is a cathode, the second electrode EL2 may be an anode, for example. The second electrode EL2 may be a transmissive electrode, a transflective electrode, or a reflective electrode.

The capping layer CPL may be further disposed on the second electrode EL2. The capping layer CPL may include a plurality of layers or a single layer. In an embodiment, the capping layer CPL may be an organic layer or an inorganic layer. In an embodiment, when the capping layer CPL includes an inorganic material, the inorganic material may include an alkali metal compound such as LiF, an alkaline earth metal compound such as MgF₂, SiON, SiNx, SiO_{y}, etc., for example. In an embodiment, when the capping layer CPL includes an organic material, the organic material may include α-NPD, NPB, TPD, m-MTDATA, Alq₃, CuPc, N4,N4,N4',N4'-tetra (biphenyl-4-yl) biphenyl-4,4'-diamine ("TPD15"), 4,4',4"-tris (carbazol-9-yl) triphenylamine ("TCTA"), etc., or include an epoxy resin, or acrylate such as methacrylate, for example. However, embodiments of the inventive concept are not limited thereto.

The encapsulation layer TFE may be disposed on the light-emitting element ED. The encapsulation layer TFE may be disposed while covering the light-emitting element ED. The encapsulation layer TFE may fill a portion of the pixel opening OH and may be disposed on the capping layer CPL. FIG. 4A and FIG. 4B illustrate the encapsulation layer TFE as a single layer, but the encapsulation layer TFE may include at least one organic film or inorganic film or include both of an organic film and an inorganic film. The encapsulation layer TFE may have a thin-film encapsulation layer structure including at least one organic film and at least one inorganic film. In an embodiment, the encapsulation layer TFE may have a structure in which an organic film and an inorganic film are alternately and repeatedly stacked, or a structure in which an inorganic film, an organic film, and an inorganic film are sequentially stacked, for example. The encapsulation layer TFE may serve as protecting the light-emitting element ED from moisture and/or oxygen and protecting the light-emitting element ED from foreign substances such as dust particles.

The inorganic film included in the encapsulation layer TFE may include, e.g., a silicon nitride layer, a silicon oxynitride layer, a silicon oxide layer, a titanium oxide layer, or an aluminum oxide layer, but embodiments of the inventive concept are not limited thereto. The organic film included in the encapsulation layer TFE may include an acrylate-based organic film, but embodiments of the inventive concept are not limited thereto.

The display module DM in an embodiment illustrated in FIG. 4A may include the color filter layer CFL disposed on the display panel DP. The color filter layer CFL illustrated in FIG. 4A may correspond to the optical layer OPL described above in FIG. 3. The color filter layer CFL may be a light control layer which selectively transmits light. In an embodiment, the color filter layer CFL may be an anti-reflective layer or a low reflective layer for reducing a reflectance for external light incident from outside a display device. In addition, the color filter layer CFL may improve color gamut of a display device by selectively transmitting portion of provided light. As used herein, the term "color gamut" refers to a range of colors that are displayable by a display device. In an embodiment, the color filter layer CFL may improve color gamut by selectively absorbing or transmitting light in a predetermined wavelength range, for example. Light passing through the color filter layer CFL and incident onto the display panel DP, etc., may be unpolarized light. The display panel DP may receive unpolarized light from above the color filter layer CFL.

The color filter layer CFL may include a filter part CF and division patterns BM in which division openings OH-BM are defined therein. The division openings OH-BM may be defined to respectively correspond to the pixel openings OH.

The filter part CF may include a first filter part CF-R which transmits first color light, a second filter part CF-G which transmits second color light, and a third filter part CF-B which transmits third color light. In an embodiment, the first filter part CF-R may be a red filter, the second filter part CF-G may be a green filter, and the third filter part CF-B may be a blue filter, for example.

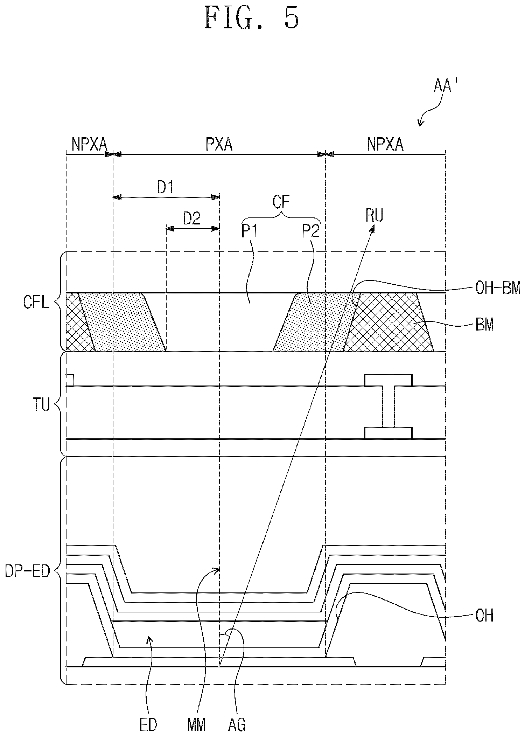

The filter part CF may include a first portion P1 and a second portion P2. In an embodiment, the first filter part CF-R may include the first portion P1 and the second portion P2. Detailed description regarding the first portion P1 and the second portion P2 will be made later with reference to FIG. 5 and subsequent drawings.

Each of the first to third filter parts CF-R, CF-G, and CF-B may include a polymer photosensitive resin and a colorant. Each of the first to third filter parts CF-R, CF-G, and CF-B may include a pigment or a dye. The first filter part CF-R may include a first colorant, the second filter part CF-G may include a second colorant, and the third filter part CF-B may include a third colorant. The first filter part CF-R may include a red pigment or dye, the second filter part CF-G may include a green pigment or dye, and the third filter part CF-B may include a blue pigment or dye. Embodiments of the inventive concept are not limited thereto, and the third filter part CF-B may not include a pigment or a dye. In an embodiment, the third filter part CF-B may include or consist of a transparent photosensitive resin, and the third filter part CF-B may be transparent, for example. When the third filter part CF-B includes or consists of a transparent photosensitive resin, light transmitted by the third filter part CF-B is not limited to the third color light.

The color filter layer CFL may include the division patterns BM. The color filter layer CFL may include the division patterns BM disposed to overlap boundaries of neighboring first to third filter parts CF-R, CF-G, and CF-B. The division patterns BM may be disposed to correspond to the non-light-emitting region NPXA, and the first to third filter parts CF-R, CF-G, and CF-B may be disposed to respectively correspond to the first light-emitting region PXA-R, the second light-emitting region PXA-G, and the third light-emitting region PXA-B. The division patterns BM may be spaced apart from each other. The division patterns BM may be a black matrix for preventing a light leakage phenomenon. The division patterns BM may be formed while including an inorganic light-shielding material or an organic light-shielding material including a black pigment or a black dye. The division patterns BM may define boundaries between neighboring first to third filter parts CF-R, CF-G, and CF-B. In an alternative embodiment, in an embodiment, the division patterns BM may include or consist of blue filters.

The color filter layer CFL may further include an overcoat layer OC. The overcoat layer OC may cover filter parts CF and the division patterns BM. The overcoat layer OC may overlap an entirety of the display element layer DP-ED. An upper surface of the overcoat layer OC may define an upper surface of the color filter layer CFL and cover a front surface of the display panel DP to protect the display panel DP.

The display module DM in an embodiment may include the sensor layer TU disposed between the display panel DP and the color filter layer CFL. The sensor layer TU may include a sensor base layer BS-TU, a first conductive layer SP1, an inorganic insulating layer IL, a second conductive layer SP2, and an organic insulating layer OL. The first conductive layer SP1 may be disposed on the sensor base layer BS-TU. The inorganic insulating layer IL may cover the first conductive layer SP1 and may be disposed on the sensor base layer BS-TU and the first conductive layer SP1. The second conductive layer SP2 may be disposed on the inorganic insulating layer IL. The organic insulating layer OL may cover the second conductive layer SP2 and may be disposed on the inorganic insulating layer IL and the second conductive layer SP2.

The sensor base layer BS-TU may be an inorganic layer including any one of silicon nitride, silicon oxynitride, or silicon oxide. In an alternative embodiment, the sensor base layer BS-TU may be an organic layer including an epoxy resin, an acryl resin, or an imide-based resin. The sensor base layer BS-TU may have a single-layered structure or a multi-layered structure in which layers are stacked along a third direction DR3. The sensor base layer BS-TU may be directly disposed on the encapsulation layer TFE.

Each of the first conductive layer SP1 and the second conductive layer SP2 may have a single-layered structure or a multi-layered structure in which layers are stacked along the third direction DR3. The conductive layers SP1 and SP2 each having a single-layered structure may include a metal layer or a transparent conductive layer. The metal layer may include molybdenum, silver, titanium, copper, aluminum, or alloy thereof. The transparent conductive layer may include a transparent conductive oxide such as indium tin oxide ("ITO"), indium zinc oxide ("IZO"), zinc oxide (ZnO), and indium zinc tin oxide ("IZTO"). In addition, the transparent conductive layer may include a conductive polymer such as poly(3,4-ethylenedioxythiophene) ("PEDOT"), a metal nanowire, graphene, etc.

The conductive layers SP1 and SP2 each having a multi-layered structure may include metal layers. The metal layers may have a three-layered structure of titanium (Ti)/aluminum (Al)/titanium (Ti) for example. The conductive layers SP1 and SP2 each having a multi-layered structure may include at least one metal layer and at least one transparent conductive layer.

The inorganic insulating layer IL may include at least one of aluminum oxide, titanium oxide, silicon oxide, silicon oxynitride, zirconium oxide, or hafnium oxide.

A contact hole CN may be defined in the inorganic insulating layer IL. The first conductive layer SP1 and the second conductive layer SP2 may be electrically connected through the contact hole CN. The contact hole CN may be filled with a material of the second conductive layer SP2.

The organic insulating layer OL may cover the inorganic insulating layer IL and the second conductive layer SP2. The organic insulating layer OL may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, or a perylene-based resin.

A display module DM-1 in an embodiment illustrated in FIG. 4B is different from the display module DM illustrated in FIG. 4A in that a color filter layer CFL-1 does not include separate division patterns BM (refer to FIG. 4A). In an embodiment, the color filter layer CFL-1 may not include the separate division patterns BM (refer to FIG. 4A) and may include portions in which a plurality of filter parts CF-R, CF-G, and CF-B are disposed to overlap each other in a third direction DR3 that is a thickness direction. First to third filter parts CF-R, CF-G, and CF-B may all overlap, and thus the portions may serve the same role as a black matrix. In an embodiment, the portions in which the first to third filter parts CF-R, CF-G, and CF-B are disposed to overlap each other may be also referred to as division patterns.

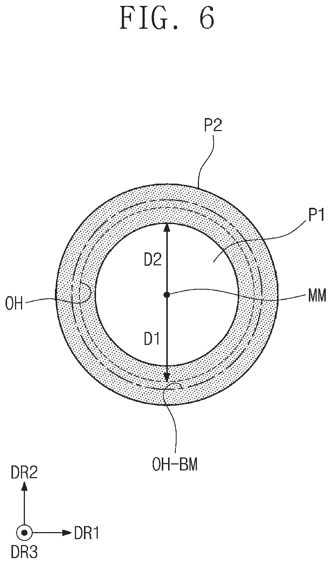

FIG. 5 is an enlarged cross-sectional view of an embodiment of a portion of a display device according to the inventive concept. FIG. 6 is a plan view illustrating some components of an embodiment of a display device according to the inventive concept. FIG. 5 illustrates an enlarged cross section corresponding to region AA' in FIG. 4A for more detailed illustration of the color filter layer CFL. FIG. 6 is an enlarged plan view illustrating some of components illustrated in FIG. 5 for more detailed illustration of the first portion P1 and the second portion P2. FIG. 6 illustrates the pixel opening OH, a division opening OH-BM, the first portion P1, etc., have circular shapes in a plan view, but are not limited thereto such a shape. Thus, the pixel opening OH, a division opening OH-BM, the first portion P1, etc., may have various shapes in a plan view such as an oval shape, a quadrangle, a polygon, a triangle, or an arbitrary shape when desired. The color filter layer CFL according to the inventive concept will be more specifically described below with reference to FIG. 5, FIG. 6, and FIG. 4A described above. The same component as the component described above will be denoted as the same reference numerals or symbols, and detailed description thereof will be omitted.

The color filter layer CFL includes the first portion P1 and the second portion P2 surrounding the first portion P1. At least one filter part among a plurality of filter parts CF-R, CF-G, and CF-B may include the first portion P1 and the second portion P2. In an embodiment, the first filter part CF-R may include the first portion P1 and the second portion P2, for example. As used herein, the term "color filter" may refer to any one filter part, among the plurality of filter parts CF-R, CF-G, and CF-B, including the first portion P1 and the second portion P2. Among the plurality of filter parts CF-R, CF-G, and CF-B, any one filter part CF including the first portion P1 and the second portion P2 may be also referred to as a color filter CF.

The filter part (hereinafter also referred to as a color filter) CF includes the first portion P1 and the second portion P2. The first portion P1 overlaps a light-emitting region PXA. The first portion P1 may overlap a portion of the light-emitting region PXA and may not overlap the non-light-emitting region NPXA. The first portion P1 may not contact the division patterns BM. The first portion P1 may be spaced apart from the division patterns BM by a predetermined distance in a plan view. The first portion P1 may be defined as an adjacent portion with respect to a centerline MM. The centerline MM may refer to one axis extending in the third direction DR3 from a center of the light-emitting region PXA in a plan view. As used herein, the light-emitting region PXA may refer to one light-emitting region, among light-emitting regions PXA-R, PXA-G, and PXA-B, corresponding to the color filter CF. In an embodiment, the centerline MM may refer to one axis extending in a third direction DR3 along a center of a plane defined by a first direction DR1 and a second direction DR2 in the first light-emitting region PXA-R, for example. The first portion P1 may overlap a center portion of the light-emitting region PXA adjacent to the centerline MM.

The first portion P1 may have a shape to correspond to the light-emitting region PXA. The light-emitting region PXA may have a first width D1 in one direction from the centerline MM, and the first portion P1 may have a second width D2 in the one direction from the centerline MM. A length ratio of the second width D2 to the first width D1 may be about 0.4 to about 0.6. In an embodiment, the first width D1 may be about 6 micrometers (µm) to about 20 µm, and the second width D2 may be about 3 µm to about 10 µm. In an embodiment, the first width D1 may be about 11 µm to about 15 µm, and the second width D2 may be about 4 µm to about 7 µm, for example.

The second portion P2 may overlap the light-emitting region PXA and the non-light-emitting region NPXA. The second portion P2 may contact the first portion P1, and the second portion P2 may contact the division patterns BM. The second portion P2 may contact at least a portion of a side surface of the division opening OH-BM. The second portion P2 may overlap an edge portion of the light-emitting region PXA spaced apart from the centerline MM and the non-light-emitting region NPXA. The second portion P2 may be defined as a portion of the color filter CF overlapping a traveling direction of transmitted light RU. The transmitted light RU may refer to any light, of light emitted from the light-emitting element ED, perceived by a user of a display device DD within a first angle AG range with respect to the third direction DR3 that is a normal direction of a center of an upper surface of the first electrode EL1. The first angle AG may be about 30 degrees to about 60 degrees. Light emitted from the light-emitting element ED may be also referred to as "source light".

The color filter CF includes a colorant. The color filter CF may include a pigment or a dye. In an embodiment, the color filter CF may include a red pigment or a red dye, for example. Since the color filter CF includes the colorant, the color filter CF may absorb at least portion of light emitted from the light-emitting element ED. In an embodiment, the color filter CF may absorb at least portion of the first light emitted from the first light-emitting element ED-1, for example.

A percentage by mass of a colorant included in the first portion P1 with respect to a total weight of the first portion P1 is a first mass percent, and a percentage by mass of a colorant included in the second portion P2 with respect to a total weight of the second portion P2 is a second mass percent which is greater than the first mass percent. A ratio of the first mass percent to the second mass percent may be about 0.50 to about 0.97. In an embodiment, the ratio of the first mass percent to the second mass percent may be about 0.80 to about 0.92, for example. However, the ratio of the first mass percent to the second mass percent is not limited thereto and may vary when desired. In an embodiment, the ratio of the first mass percent to the second mass percent may be within a predetermined range depending on a ratio of a light transmittance of the first portion P1 to a light transmittance of the second portion P2, for example. The first portion P1 may include a colorant to have a first concentration, and the second portion P2 includes a colorant to have a second concentration which is higher than the first concentration. The second portion P2 may be defined as a portion, of the color filter CF, having a relatively high concentration of a colorant.

In an embodiment, the first portion P1 may include a polymer photosensitive resin and a (1-1)-th colorant, and the second portion P2 may include a polymer photosensitive resin and a (1-2)-th colorant. The (1-1)-th colorant and the (1-2)-th colorant may consist of the same material, include the same material, or may consist of different materials from each other. The (1-1)-th colorant and the (1-2)-th colorant may each independently be a red pigment or a red dye. A percentage by mass of the (1-1)-th colorant with respect to a total weight of the first portion P1 may be a first mass percent, and a percentage by mass of the (1-2)-th colorant with respect to a total weight of the second portion P2 may be a second mass percent which is greater than the first mass percent. The (1-1)-th colorant may have a first concentration in the first portion P1, and the (1-2)-th colorant may have a second concentration in the second portion P2, which is higher than the first concentration.

A light transmittance of the color filter CF with respect to visible light may become lower in a direction of getting farther away from the centerline MM. A light transmittance of the first portion P1 may be higher than a light transmittance of the second portion P2. The light transmittance of the second portion P2 may be lower than the light transmittance of the first portion P1 and higher than a light transmittance of the division patterns BM. With respect to light in a wavelength range of about 600 nm to about 700 nm, the light transmittance of the first portion P1 may be higher than the light transmittance of the second portion P2. In an embodiment, the light transmittance of the second portion P2 may be about 82% to about 92% of the light transmittance of the first portion P1, for example. The light transmittance of the second portion P2 with respect to visible light may become lower in a direction of getting farther away from the centerline MM. In an embodiment, the light transmittance of the second portion P2 adjacent to the first portion P1 may be about 82% to about 85% of the light transmittance of the first portion P1, and the light transmittance of the second portion P2 overlapping the non-light-emitting region NPXA may be about 88% to about 91% of the light transmittance of the first portion P1, for example. Since the second concentration in the second portion P2 may be higher than the first concentration in the first portion P1, an absorbance of the second portion P2 may be higher than an absorbance of the first portion P1, and thus the light transmittance of the first portion P1 may be higher than the light transmittance of the second portion P2.

Among the plurality of filter parts CF-R, CF-G, and CF-B, the first filter part CF-R may include the first portion P1 and the second portion P2 described above, and the second filter part CF-G and the third filter part CF-B may not include the first portion P1 and the second portion P2. The first portion P1 of the first filter part CF-R may include the first colorant to have a first concentration, and the second portion P2 of the first filter part CF-R includes the first colorant to have a second concentration which is higher than the first concentration. The second filter part CF-G may include the second colorant, and a concentration of the second colorant may be substantially uniform in a surface of the second filter part CF-G. That is, the second filter part CF-G may not include a plurality of regions having different concentrations of the second colorant.

A first light transmittance of the first portion P1 in the first filter part CF-R with respect to the first light may be relatively high compared to a second light transmittance of the second portion P2 in the first filter part CF-R with respect to the first light. The second light transmittance may be about 82% to about 90% of the first light transmittance. In an embodiment, the second light transmittance may be about 87% to about 89% of the first light transmittance, for example. However, a value of the second light transmittance is not limited thereto and may vary when desired. In addition, a light transmittance of the second filter part CF-G with respect to the second light and a light transmittance of the third filter part CF-B with respect to the third light may be substantially same in a plan view. That is, the second filter part CF-G and the third filter part CF-B may not include a plurality of regions having different light transmittances with respect to the second light or the third light.

Hereinafter, evaluation results of the characteristics of a display device in an embodiment of the inventive concept will be described with reference to the drawings described above, and Embodiment and Comparative Example to be described below. In addition, Embodiment to be shown below is one of embodiments for an understanding of the inventive concept, and the scope of the inventive concept is not limited thereto.

In Embodiment and Comparative Example below, display devices were manufactured to have the same structure except for the color filter layer CFL. Embodiment of the display device was manufactured to have a structure of the display device DD in FIG.4A in which the first filter part CF-R includes the first portion P1 and the second portion P2. Embodiment of the display device was manufactured such that a first concentration of a colorant included in the first portion P1 was lower than a second concentration of a colorant included in the second portion P2. On the contrary, Comparative Example of the display device was manufactured to have a structure in which the first filter part CF-R does not include the first portion P1 and the second portion P2. Comparative Example of the display device was manufactured such that a concentration of a colorant included in the first filter part CF-R was substantially uniform in a plan view.

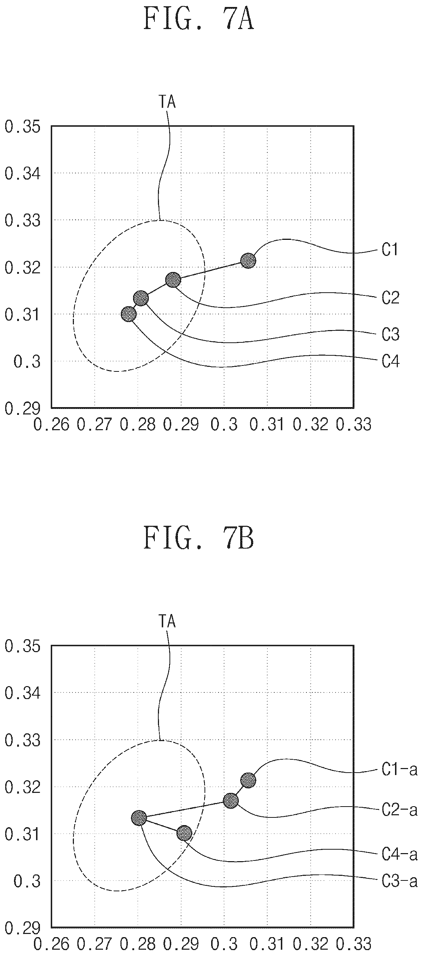

FIG. 7A is a graph showing Embodiment of color coordinates versus viewing angles, and FIG. 7B is a graph showing Comparative Example of color coordinates versus viewing angles.

Referring to FIG. 7A and FIG. 7B, first points C1 and C1-a show color coordinates at a viewing angle of about 0 degree, second points C2 and C2-a show color coordinates at a viewing angle of about 30 degrees, third points C3 and C3-a show color coordinates at a viewing angle of about 45 degrees, and fourth points C4 and C4-a show color coordinates at a viewing angle of about 60 degrees. The viewing angles may be angles inclined with respect to a third direction DR3 that is a normal direction of the display surface IS (refer to FIG. 1).

Referring to FIG. 7A, in Embodiment of a display device DD, the second point C2 showing a color coordinate at a viewing angle of about 30 degrees, the third point C3 showing a color coordinate at a viewing angle of about 45 degrees, and the fourth point C4 showing a color coordinate at a viewing angle of about 60 degrees are all disposed within a target region TA. On the contrary, referring to FIG. 7B, in Comparative Example of a display device, the third point C3-a showing a color coordinate at a viewing angle of about 45 degrees and the fourth point C4-a showing a color coordinate at a viewing angle of about 60 degrees are disposed within the target region TA, but the second point C2-a showing a color coordinate at a viewing angle of about 30 degrees is disposed outside the target region TA.

A white color coordinate at a viewing angle of about 45 degrees may be adjusted to a predetermined color coordinate by adjustment of a thickness of the light-emitting element ED included in the display element layer DP-ED. The target region TA for a color coordinate may be determined on the basis of the white color coordinate at a viewing angle of about 45 degrees. When each of white color coordinates at viewing angles of about 30 degrees and about 60 degrees is disposed within the target region TA, white angular dependency according to a viewing angle may be reduced, and thus the display device DD may have improved reliability. Since Embodiment of the display device DD includes the first portion P1 and the second portion P2 having different concentrations of a colorant, it is understood that both white color coordinates at viewing angles of about 30 degrees and about 60 degrees are disposed within the target region TA, and thus the display device DD has improved reliability, compared to Comparative Example of the display device.

As discussed, embodiments may provide a display device comprising: a base layer including a light-emitting region and a non-light-emitting region adjacent to the light-emitting region; a display element layer disposed on the base layer and including a light-emitting element corresponding to the light-emitting region; and a color filter disposed on the display element layer and including a colorant, the color filter including: a first portion overlapping the light-emitting region; and a second portion surrounding the first portion, wherein a first weight percent of the colorant with respect to a total weight of the first portion is smaller than a second weight percent of the colorant with respect to a total weight of the second portion.

The first portion may have a shape to correspond to the light-emitting region. For example, the light-emitting region may have various shapes in a plan view such as an oval shape, a quadrangle, a polygon, a triangle, or an arbitrary shape when desired.

The first portion may have a smaller area than that of the light-emitting region when consider in in a plan view. Hence, in some embodiments the first portion is within the light-emitting region when considered in plan view, and only overlaps the light-emitting region and not the non-light-emitting region.

The second portion may completely surround the first portion. The second portion may overlap a portion of the light-emitting region and a portion of the non-light-emitting region.

The colorant may include a red pigment or a red dye, and a binder or resin.

A ratio of the first mass percent to the second mass percent may be about 0.50 to about 0.97. In an embodiment, the ratio of the first mass percent to the second mass percent may be about 0.80 to about 0.92, for example.

The first portion may include the colorant at a first concentration, and the second portion may includes the colorant at a second concentration which is higher than the first concentration. The second portion may be defined as a portion of the color filter, having a relatively high concentration of a colorant.

The display device may comprise a plurality of sub-pixels arranged to emit light. The light-emitting element may a red light-emitting element, and the color filter including the first portion and the second portion may correspond to a red subpixel. Other sub-pixels (e.g. green or blue sub-pixels) may have their own light-emitting elements and color filters. In some embodiments, the color filters of sub-pixels emitting colors other than red do not have the first and second portions, instead having a uniform color filter.

In some embodiments, the display device comprises a plurality of sub-pixels arranged to emit light, and the light-emitting element is a red light-emitting element, and the color filter including the first portion and the second portion is a red filter.

The display device may comprise second light-emitting elements arranged to emit light of a color other than red, and second color filters that are a uniform color filter for the color other than red. The second color filters may be green filter and the second light-emitting elements may emit green light.

The display device may comprise third light-emitting elements arranged to emit light of another color other than red, and third color filters that are a uniform color filter for the another color other than red. The third color filters may be blue filters, and the third light-emitting elements may emit blue light.

A display device in an embodiment of the inventive concept includes a first portion and a second portion having different concentrations of a colorant in a color filter layer. The display device in an embodiment of the inventive concept includes the second portion, and may thus relatively reduce a light transmittance at a predetermined viewing angle. Specifically, an absorbance may be relatively higher when light emitted from a light-emitting element passes through the second portion having a relatively high concentration of a colorant in one color filter, than when the light passes through the first portion. The second portion may be provided for adjustment of an absorbance at a viewing angle of about 30 degrees to about 60 degrees. A first filter part of a display device in an embodiment may include the first portion and the second portion, and a second filter part and a third filter part may not include the first portion and the second portion. Accordingly, the display device in an embodiment may make it possible to prevent a display surface from appearing red at a predetermined viewing angle and reduce a color tone difference according to a viewing angle, thereby improving display quality of the display device.

In an embodiment of the inventive concept, a display device includes a color filter layer including portions having different concentrations of a colorant. Accordingly, the display device including the color filter layer in an embodiment of the inventive concept may reduce white angular dependency according to a viewing angle.

Although the embodiments of the inventive concept have been described, it is understood that the inventive concept should not be limited to these embodiments, but various changes and modifications may be made by one ordinary skilled in the art within the scope of the inventive concept as hereinafter claimed. Therefore, the technical scope of the inventive concept is not limited to the contents described in the detailed description of the specifications but should be defined by the accompanying claims.

## Claims

1. A display device comprising:
a base layer including a light-emitting region and a non-light-emitting region adjacent to the light-emitting region;
a display element layer disposed on the base layer and including a light-emitting element corresponding to the light-emitting region; and
a color filter disposed on the display element layer and including a colorant, the color filter including:
a first portion overlapping the light-emitting region; and
a second portion surrounding the first portion,
wherein a first weight percent of the colorant with respect to a total weight of the first portion is smaller than a second weight percent of the colorant with respect to a total weight of the second portion.

2. The display device of claim 1, wherein the colorant includes a dye or a pigment.

3. The display device of claim 1 or 2, wherein the second portion overlaps a portion of the light-emitting region and a portion of the non-light-emitting region.

4. The display device of any one of claims 1 to 3, wherein the light-emitting element is arranged to emit source light, and
the color filter is arranged to absorb at least portion of the source light.

5. The display device of claim 4, wherein, with respect to the source light, a first light transmittance of the first portion is higher than a second light transmittance of the second portion.

6. The display device of claim 5, wherein the second light transmittance is about 82 percent to about 90 percent of the first light transmittance.

7. The display device of claim 5 or 6, further comprising a division pattern apposed to the color filter on the display element layer and overlapping the non-light-emitting region,
wherein, with respect to the source light, a light transmittance of the division pattern is lower than the second light transmittance.

8. The display device of any one of claims 4 to 7, wherein an absorbance of the first portion with respect to the source light is lower than an absorbance of the second portion with respect to the source light.

9. The display device of any one of claims 1 to 8, wherein a centerline which is virtual is defined in the light-emitting region in a plan view, and
the first portion is defined as a portion adjacent to the centerline.

10. The display device of claim 9, wherein the light-emitting element is arranged to emit source light, and
a light transmittance of the color filter with respect to the source light becomes lower in a direction of getting farther away from the centerline in the plan view.

11. The display device of claim 9 or 10, wherein the light-emitting region has a first width with respect to a first direction from the centerline,
the first portion has a second width with respect to the first direction from the centerline to correspond to the light-emitting region, and
a ratio of the second width to the first width is about 0.4 to about 0.6.

12. The display device of claim 11, wherein the first width is about 6 micrometers to about 20 micrometers, and
the second width is about 3 micrometers to about 10 micrometers.

13. The display device of any one of claims 1 to 12, further comprising an overcoat layer which covers the color filter and overlapping an entirety of the light-emitting region and the non-light-emitting region.

14. The display device of any one of claims 1 to 13, wherein the display device comprises a plurality of sub-pixels arranged to emit light, and the light-emitting element is a red light-emitting element, and the color filter including the first portion and the second portion is a red filter.

15. The display device of claim 14, wherein the display device further comprises second light-emitting elements arranged to emit light of a color other than red, and second color filters that are a uniform color filter for the color other than red.
